# EUROPEAN PATENT SPECIFICATION

(11) **EP 0 654 137 B1**
(45) Date of publication and mention of the grant of the patent: **29.12.1997**
(21) Application number: 94918597.9
(22) Date of filing: 15.06.1994
(51) Int. Cl.: F24F 13/20, H05K 5/04, H01R 4/64

(54) **AN EARTH SYSTEM FOR A WINDOW-TYPE AIR CONDITIONER**
ERDVERBINDUNG FÜR EINE FENSTER-KLIMAANLAGE
SYSTEME DE MISE A LA TERRE POUR CLIMATISEUR TYPE FENETRE

(30) Priority: 15.06.1993 KR 1000494 U
(43) Date of publication of application: 24.05.1995
(73) Proprietor: Samsung Electronics Co., Ltd., Suwon-City, Kyungki-do 441-742 (KR)
(72) Inventor: JEONG, Ju, Yeul, Dobong-gu Seoul 132-041 (KR)
(74) Representative: Kahler, Kurt, Dipl.-Ing.
(86) International application number: KR9400071
(87) International publication number: WO9429651

(56) References cited:
- AT-B- 312 215
- DE-A- 3 835 695
- DE-A- 4 039 413

## Description

### BACKGROUND OF THE INVENTION

This invention is related to an earth device for a window-type air conditioner, and more particularly, to an earth system with at least one grounded protrusion which is formed on both sides of the bottom surface of an outer case and which forces the outer case to be directly grounded to the bottom surface, when the air conditioner unit is inserted into the outer case.

Air-conditioners generally cool room air, using a refrigerating cycle. The refrigerating cycle includes a compression type refrigerator. The refrigerant is compressed in the high temperature and the high pressure state by a compressor, being liquified in a condensing unit with the forced cooling of a blower, being decompressed passing through a capillary tube and then absorbs heat from room air while being gasified in an evaporator. At that time, room air intaken by the blower is passed through the evaporator to be cooled and then discharged indoors.

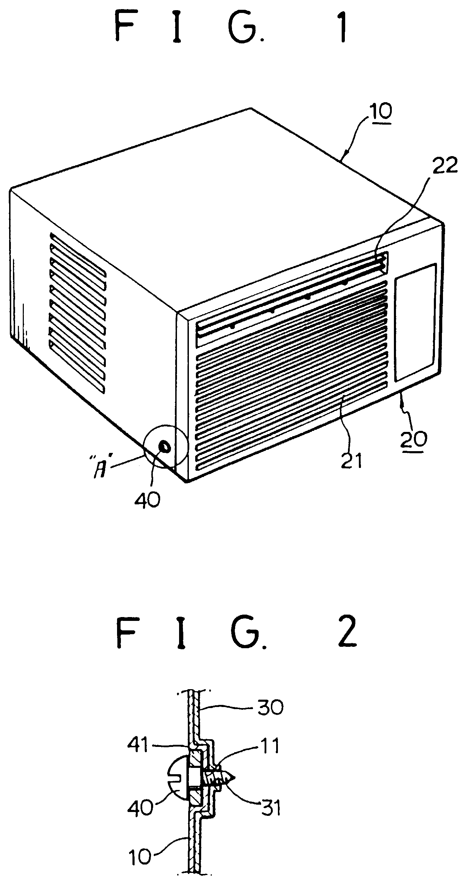

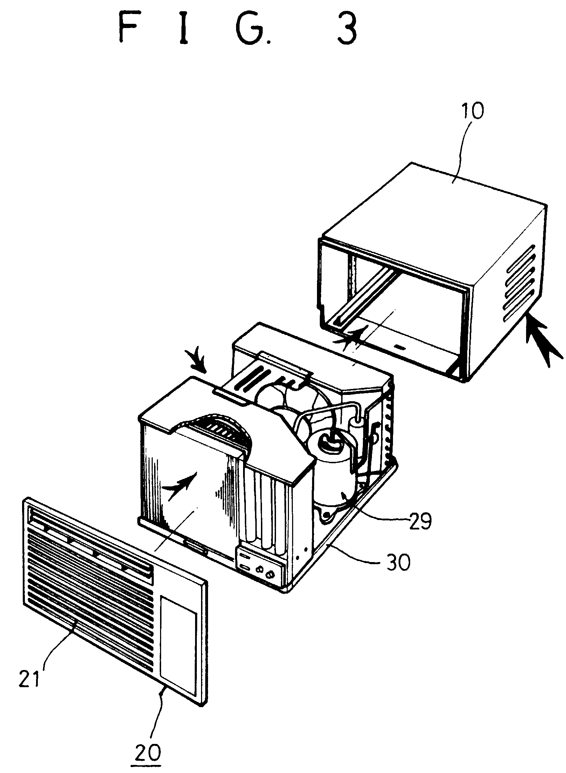

These window-type air conditioners comprise an outer case 10 in a box shape, as shown in Fig. 1 and Fig. 3, and generally comprise a compartment having an evaporator, which is disposed at an indoor side; a compartment having a compressor and a condenser, which are disposed at an outdoor side; and a partition dividing the compartments, in which the outer case 10 includes a front plate 20 formed on its front surface, on the surface of which an inlet portion 21 introducing room air thereinto and an outlet portion 22 discharging heat-exchanged air outward from indoors.

On the other hand, as the general window type air-conditioner lowers room temperature by heat-exchanging refrigerant with room air at the evaporator, moisture contained in room air is condensed by the dewing phenomena. Especially, in the summer season of high humidity, moisture condensed by the evaporator is increased a lot, so the electrical insulating state becomes worse, and the current applied to the compressor leaks through an electric connection point. Further, the electrical devices of the air conditioner are shorted with the outer case to discharge the leakage current.

In order to prevent this electric leakage, the conventional air conditioners have a separate grounded line or uses a different metal coupling member to keep the outer case and other parts of the air-conditioner grounded.

The conventional earth device includes a coupling member. As shown in the "A" part of Fig. 1, Fig. 2 and Fig. 3, the earth device is constructed so that a coupling hole 11 is formed on the side walls of the outer case 10, a washer 41 is fitted into the peripheral portion of the coupling hole 11, and a coupling member 40 gets an unit base 30 and an outer case 10 to be integrally coupled. Thus, the outer case 10 is electrically connected with the unit base 30, while the outer case 10 is grounded.

The typical example of the earth device in the air-conditioner is disclosed to Japanese Utility Model Laid Open No. 60-4826. The earth device includes the grounded line which is detachably connected between a box of electrical mechanisms and an outer case so that the air-conditioner is grounded.

However, the prior earth device has problems that numerous parts are required, its assembling and disassembling works are troublesome and the manufacturing cost become increased.

AT-B-312 215 discloses an outer casing for enclosing an air-conditioner unit to be received therein, with a support plate on the bottom of the casing.

A mechanical and electrical connection between two parts of a casing is known from DE-A-38 35 695.

### SUMMARY OF THE INVENTION

Accordingly, in order to resolve these problems and disadvantages in the prior art, an object of the present invention is to provide an earth system of a window-type air conditioner for facilitating the assembly and disassembly of an outer case with an air-conditioner unit and for simplifying the air-conditioner to be grounded.

Another object of the present invention is to provide an earth system of a window-type air conditioner for reducing the manufacturing cost by achieving a simple construction.

The present invention comprises a grounded protrusion on the upper surface of a rail, which is formed on both sides of the bottom of an outer case, so that the grounded protrusion enables the metallic portion of an air-conditioner unit to that of an outer case with the painting film of the bottom surface of the unit base being taken off, when the air-conditioner unit is inserted into the outer case, thereby grounding the air-conditioner.

### BRIEF DESCRIPTION OF THE DRAWING

An embodiment of the invention will now be described by way of example and with reference to the accompanying drawings, in which:

Fig. 1 is a perspective view of the general window-type air conditioner.

Fig. 2 is a sectional view of the conventional earth device.

Fig. 3 is an exploded perspective view of the general window-type air conditioner.

Fig. 4 is a perspective view of the outer case according to the present invention.

Fig. 5 is a sectional view of an earth system according to the present invention.

### DETAILED DESCRIPTION OF THE INVENTION

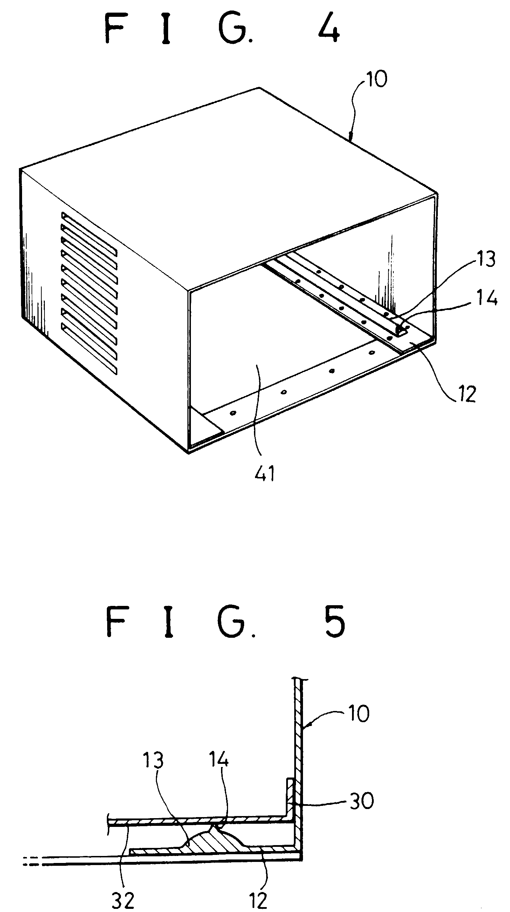

Fig. 1 is a perspective view of the general window-type air conditioner, Fig. 3 is a view illustrating the interior portion of the air conditioner and Fig. 4 is a perspective view illustrating an outer case adapted to the invention.

The window-type air conditioner generally comprises an outer case 10 in the form of a box and an air conditioner unit 29. The air-conditioner unit 10 includes an indoor side compartment having an evaporator arranged therein and an outdoor side compartment having a compressor and a condenser arranged therein. The outer case 10 includes a front plate 20 which is provided with an intake 21 for intaking room air and an outlet 22 for discharging heat-exchanged air passing through the evaporator into the room.

On the other hand, an earth system of the invention comprises an outer case 10 as shown in Fig. 4, in which the outer case 10 also includes a rail formed longitudinally along support plates 12 which are extended inward from both sides of the outer case 10. The rail 13 is expanded up in a dome shape. It enables the air-conditioner unit 29 to be guided forward and rearward in a longitudinal direction, contacting with a bottom surface 32 of an unit base 30, thereby detachably mounting into the outer case 10.

Also, the earth system in accordance with the invention is provided with a protrusion 14 that the upper end of the rail 13 is sharply protruded to the predetermined height.

Therefore, the earth system according to the invention enables the assembly of the air-conditioner and has the acting-effect as follows:

First, the air conditioner unit 29 including the indoor side compartment and the outdoor side compartment is placed on the rail 13 formed on the support plates 12 of the outer case 10. The air conditioner unit 29 is pushed inward toward the rear portion of the outer case 10 to move along the rail 13, while a painting film formed on the bottom surface 32 is cut out or stripped off by the sharp protrusion 14. At that time, the metal portion of the unit base 30 is contacted with the metal portion of the outer case 10. It makes the electrical contact between the air-conditioner unit 29 and the outer case 10, so that the air-conditioner can be easily grounded, and the leaked current be applied to the ground during the cooling operation. In addition, a plurality of grounded protrusions 14 may be properly formed on the rail 13 at the predetermined intervals, thereby achieving the reliable electrical contact.

Accordingly, the invention enables the grounded protrusion 14 formed on the rails 13, which are expanded on both bottom extended sides of the outer case 10, to electrically operates contact the unit base with the outer case, so that the leaked current is easily grounded. Also, such like a simple configuration simplifies the assembly and disassembly of the outer case of the air-conditioner unit and reduces the manufacturing cost of the system.

## Claims

1. An earth system of a window-type air-conditioner comprising:
an outer case (10) for enclosing an air-conditioner unit (29) to be received therein;
a support plate (12) extending inward from both sides of the bottom of said outer case;
at least one rail (13) extending longitudinally on said support plate (12), its section having a semicircle shape; and
at least one grounded protrusion (14) formed on said rail (13) in the form of a pointed tip.

2. The earth system of the window-type air-conditioner according to claim 1,
wherein said grounded protrusion (14) gets said air-conditioner unit (29) to be contacted with said outer case (10) by stripping off a paint film formed on the base surface of said air-conditioner unit (29), when said air-conditioner unit is mounted in said outer case (10) on said rail (13).

3. The earth system for the window-type air-conditioner according to claim 1 or 2,
wherein a plurality of said grounded protrusions (14) are formed on said rail (13) at an interval.

## Patentansprüche

1. Erdungssystem einer Fenster-Klimaanlage, aufweisend:
ein äußeres Gehäuse (10) zum Umschließen einer darin aufzunehmenden Klimaanlageneinheit (29);
eine Stützplatte (12), die sich von beiden Seiten des Bodens des äußeren Gehäuses nach innen erstreckt;
zumindest eine Schiene (13), die sich an der Stützplatte (12) längs erstreckt, wobei deren Querschnitt eine halbkreisförmige Gestalt aufweist; und
zumindest einen geerdeten Vorsprung (14), der an der Schiene (13) in Form eines spitzen Endstücks ausgebildet ist.

2. Erdungssystem der Fenster-Klimaanlage nach Anspruch 1,
wobei der geerdete Vorsprung (14) die Klimaanlageneinheit (29) mit dem äußeren Gehäuse (10) durch Abstreifen einer Farbschicht, die an der Grundplattenfläche der Klimaanlageneinheit (29) ausgebildet ist, in Kontakt bringt, wenn die Klimaanlageneinheit in dem äußeren Gehäuse (10) auf der Schiene (13) befestigt wird.

3. Erdungssystem für die Fenster-Klimaanlage nach Anspruch 1 oder 2,
wobei eine Vielzahl der geerdeten Vorsprünge (14) an der Schiene (13) mit einem Abstand ausgebildet ist.

## Revendications

1. Système de mise à la terre pour climatiseur type fenêtre comprenant :
- un boîtier externe (10) destiné à contenir une unité de climatiseur (29) devant être reçue dans celui-ci ;
- une plaque de support (12) s'étendant vers l'intérieur depuis les deux côtés du fond dudit boîtier externe;
- au moins un rail (13) s'étendant longitudinalement sur ladite plaque de support (12), sa section ayant une forme semi-circulaire; et
- au moins une saillie (14) mise à la terre formée sur ledit rail (13) ayant la forme d'une extrémité pointue.

2. Système de mise à la terre pour climatiseur type fenêtre selon la revendication 1, dans lequel ladite saillie (14) mise à la terre oblige ladite unité de climatiseur (29) à être en contact avec ledit boîtier externe (10) en pelant un film peint formé sur la surface de base de ladite unité de climatiseur (29) lorsque ladite unité de climatiseur est montée dans ledit boîtier externe (10) sur ledit rail (13).

3. Système de mise à la terre pour climatiseur type fenêtre selon la revendication 1 ou 2, dans lequel plusieurs desdites saillies (14) mises à la terre sont formées sur ledit rail (13) à un intervalle.
